# EUROPEAN PATENT SPECIFICATION

(11) **EP 3 940 749 B1**
(45) Date of publication and mention of the grant of the patent: **08.10.2025**
(21) Application number: 20772917.9
(22) Date of filing: 17.03.2020
(51) Int. Cl.: H01L 21/02, H01L 21/304

(54) **COMPOSITION FOR DRYING UNEVEN PATTERN AND METHOD FOR MANUFACTURING SUBSTRATE HAVING UNEVEN PATTERN ON SURFACE**
ZUSAMMENSETZUNG ZUM TROCKNEN VON UNGLEICHMÄSSIGEN MUSTERN UND VERFAHREN ZUR HERSTELLUNG VON SUBSTRATEN MIT UNGLEICHMÄSSIGEN MUSTERN AUF DER OBERFLÄCHE
COMPOSITION POUR LE SÉCHAGE DE MOTIFS IRRÉGULIERS ET MÉTHODE DE FABRICATION D'UN SUBSTRAT DONT LA SURFACE PRÉSENTE DES MOTIFS IRRÉGULIERS

(30) Priority: 19.03.2019 JP 2019051796
(43) Date of publication of application: 19.01.2022
(73) Proprietor: Central Glass Company, Limited, Ube-shi, Yamaguchi 755-0001 (JP)
(72) Inventor: TERUI, Yoshiharu, Ube-shi, Yamaguchi 755-0001 (JP); KUMON, Soichi, Ube-shi, Yamaguchi 755-0001 (JP); FUKUI, Yuki, Ube-shi, Yamaguchi 755-0001 (JP)
(74) Representative: Manitz Finsterwald Patent- und Rechtsanwaltspartnerschaft mbB
(86) International application number: PCT/JP2020/011820
(87) International publication number: WO 2020/189688

(56) References cited:
- EP-A1- 3 435 405
- JP-A- 2013 042 093
- JP-A- 2013 042 093
- JP-A- 2013 042 094
- JP-A- 2018 110 199
- JP-A- 2019 029 491
- JP-A- 2019 029 491
- US-A1- 2017 040 154
- MENON V B ET AL: "EFFECTS OF PARTICULATE SIZE, COMPOSITION, AND MEDIUM ON SILICON WAFER CLEANING", SOLID STATE TECHNOLOGY, PENNWELL CORPORATION, TULSA, OK, US, vol. 32, no. 3, 1 March 1989 (1989-03-01), pages S07 - S12, XP000027015, ISSN: 0038-111X
- WANG GUICONG ET AL: "Research on Cleaning and Drying Process of Quartz Wafer based on Orthogonal Experiment", 2018 IEEE 4TH INFORMATION TECHNOLOGY AND MECHATRONICS ENGINEERING CONFERENCE (ITOEC), IEEE, 14 December 2018 (2018-12-14), pages 375 - 379, XP033564328, [retrieved on 20190618], DOI: 10.1109/ITOEC.2018.8740725

## Description

### TECHNICAL FIELD

The present invention relates to a composition for drying an uneven pattern and a method for manufacturing a substrate having an uneven pattern on a surface.

### BACKGROUND ART

In the manufacturing of semiconductor chips, fine uneven patterns are formed on a surface of a substrate (wafer) through film deposition, lithography, etching, or the like and then wet treatment, such as a cleaning step using water or an organic solvent, is performed in order to clean the wafer surface and a drying step is also performed in order to remove liquids such as a cleaning liquid or a rinsing liquid attached to the wafer by the wet treatment. During the drying step, it is known that, in semiconductor substrates with fine uneven patterns, deformation and collapsing of the uneven patterns may easily occur. It is considered that the cause thereof is the stress caused by surface tension occurring between the liquid attached to the uneven pattern and the semiconductor interface. Various methods have been proposed to suppress such stress and prevent the deformation and collapsing of the fine uneven patterns.

Patent Document 1 describes a method of supplying a treatment liquid including a sublimable substance in a molten state to a pattern-forming surface of a substrate, coagulating the treatment liquid on the pattern-forming surface to obtain a coagulated body, and then sublimating the coagulated body.

Patent Document 2 and Patent Document 3 describe a method of filling a recessed portion of an uneven pattern with a solution in which a sublimable substance is dissolved in a solvent, drying the solvent in the solution to precipitate a solid sublimable substance in the recessed portion, and then sublimating the sublimable substance.

Patent Document 4 discloses a substrate treating method, wherein the substrate processing liquid contains a sublimable substance in a molten state and a solvent.

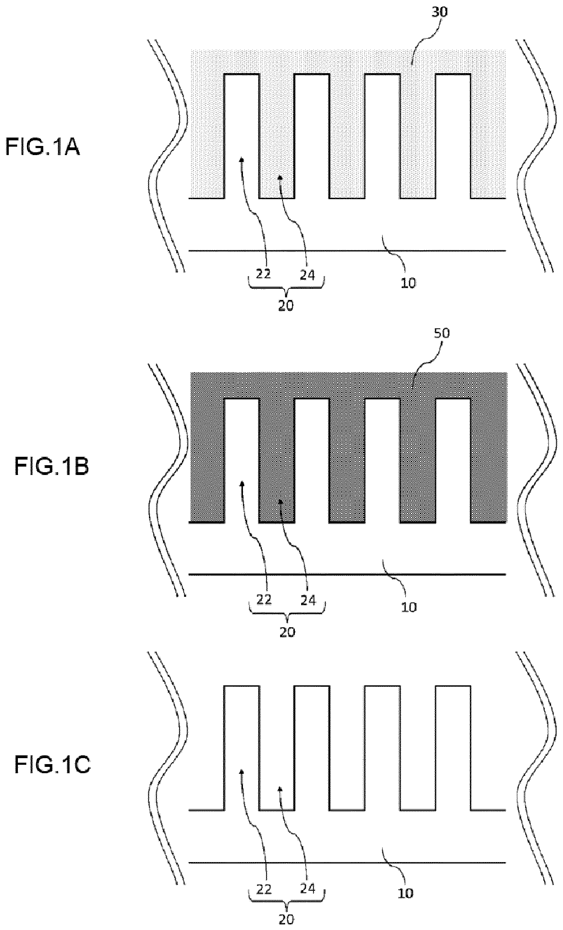

In [Non-Patent Document 1], the "Summary" section discloses that a 50:50 blend of ethanol and acetone was the best for inorganic particles, and [Non-Patent Document 2] discloses a method 3 in Fig. 1 using a mixture of Toluene, Acetone and Ethanol. In both cases a solution is provided to clean semiconductor wafers with a mixture consisting of Ethanol (boiling temperature of 78.37°C) and acetone (boiling temperature of 56.08°C).

### RELATED DOCUMENT

### PATENT AND NON-PATENT DOCUMENTS

[Patent Document 1] Japanese Unexamined Patent Application, First publication 2018-22861
[Patent Document 2] Japanese Unexamined Patent Application, First publication 2013-42093
[Patent Document 3] Japanese Unexamined Patent Application, First publication 2012-243869
[Patent Document 4] Japanese Patent Application 2019-029491 A

[Non-Patent Document 1] MENON V B ET AL: "EFFECTS OF PARTICULATE SIZE, COMPOSITION, AND MEDIUM ON SILICON WAFER CLEANING", SOLID STATE TECHNOLOGY, PENNWELL CORPORATION, TULSA, OK, US, vol. 32, no. 3, 1 March 1989 (1989-03-01), pages S07-S12, XP000027015, ISSN: 0038-111X.
[Non-Patent Document 2] WANG GUICONG ET AL: "Research on Cleaning and Drying Process of Quartz Wafer based on Orthogonal Experiment", 2018 IEEE 4TH INFORMATION TECHNOLOGY AND MECHATRONICS ENGINEERING CONFERENCE (ITOEC), IEEE, 14 December 2018 (2018-12-14), pages 375-379, XP033564328, DOI: 10.1109/ITOEC.2018.8740725, [retrieved on 2019-06-18].

### SUMMARY OF THE INVENTION

As described in Patent Documents 1 to 3, in order to dry a substrate on which an uneven pattern was formed using a sublimable substance, generally, a step is performed in which the liquid remaining in the uneven pattern (also referred to below simply as "remaining liquid") is replaced with a treatment liquid including a sublimable substance.

However, in Patent Document 1, a melt formed by melting a fluorocarbon compound, which is a sublimable substance, is used, the fluorocarbon compound may coagulate at the supply nozzle tip portion, and there is a concern that, for example, when the melt into which the coagulated material is mixed is supplied to the substrate surface, the uneven pattern will be adversely affected.

In Patent Documents 2 and 3, a solution in which a sublimable substance is dissolved in a solvent is used, thus, the problem of coagulation at the supply nozzle tip portion as in Patent Document 1 does not easily occur.

However, in recent years, with the miniaturization of uneven patterns on semiconductor wafers, the aspect ratio (height/width) of the uneven patterns has been increasing and pattern collapsing is more easily generated during the drying of the remaining liquid.

According to research by the present inventors, it was determined that, in an uneven pattern with a high aspect ratio, even in a case where a solution in which a sublimable substance is dissolved in a solvent is used, it is not possible to sufficiently suppress pattern collapsing, depending on the combination of the sublimable substance and solvent.

In addition, after supplying the solution described above to a recessed portion of an uneven pattern, the solvent in the solution is dried to coagulate the sublimable substance; however, it was determined that coagulating the sublimable substance may take a long time depending on the boiling point of the solvent.

An object of the present invention is to provide a composition for drying an uneven pattern with which coagulation at a supply nozzle tip portion is not easily generated, with which it is possible to reduce the time required for coagulation of a sublimable substance after being supplied to an uneven pattern surface, and, in particular, with which it is possible to suppress pattern collapsing when drying the uneven pattern surface, even with respect to uneven patterns with a high aspect ratio, and a method for manufacturing a substrate having an uneven pattern on a surface in which the above composition for drying is used.

As a result of intensive research to solve the problems described above, the present inventors found that it is possible to solve the problems described above with the following composition, thereby completing the present invention. That is, the present invention is as follows.

According to the present invention, there is provided a composition for drying an uneven pattern including a sublimable substance, and a solvent whose boiling point at 1 atm is lower than a boiling point or a sublimation point of the sublimable substance by 5°C or more and whose boiling point at 1 atm is 75°C or lower, wherein the sublimable substance is dissolved in the solvent, wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom, or, wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

In addition, according to the present invention, there is provided a method for manufacturing a substrate having an uneven pattern on a surface, the method including a step (I) in which, a composition for drying which contains a sublimable substance and a solvent whose boiling point at 1 atm is lower than a boiling point or a sublimation point of the sublimable substance by 5°C or more and whose boiling point at 1 atm is 75°C or lower, wherein the sublimable substance is dissolved in the solvent, is supplied, in a solution state, to a recessed portion of an uneven pattern, a step (II) in which the solvent in the recessed portion is dried and the sublimable substance is coagulated, and a step (III) of sublimating the sublimable substance, wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom, or, wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

According to the present invention, it is possible to provide a composition for drying an uneven pattern with which coagulation at a supply nozzle tip portion is not easily generated, with which it is possible to reduce the time required for coagulation of a sublimable substance after being supplied to an uneven pattern surface, and, in particular, with which it is possible to suppress pattern collapsing when drying the uneven pattern surface, even with respect to uneven patterns with a high aspect ratio, and a method for manufacturing a substrate having an uneven pattern on a surface in which the above composition for drying is used.

### BRIEF DESCRIPTION OF THE DRAWINGS

FIGs. 1A to 1C are cross-sectional views of steps in an example of steps for manufacturing a substrate.

### DESCRIPTION OF EMBODIMENTS

A detailed description will be given below of the present invention.

### [Composition for Drying Uneven Pattern]

The composition for drying an uneven pattern (also referred to simply as "composition for drying") of the present invention includes a sublimable substance and a solvent whose boiling point at 1 atm is lower than a boiling point or a sublimation point of the sublimable substance by 5°C or more and whose boiling point at 1 atm is 75°C or lower, wherein the sublimable substance is dissolved in the solvent, wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom,or wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

### <Sublimable Substance>

A description will be given of the sublimable substances included in the composition for drying of the present invention.

In the present specification, "sublimable substance" refers to substance having a vapor pressure in a solid state.

In principle, it is possible to use the sublimable substance in the present invention as long as the substance is solid and has a vapor pressure at a specific temperature; however, in a case where an extremely low temperature is required for coagulation or in a case where an extremely high temperature is required for sublimation, there is a concern that the apparatus may be complicated or there may be an adverse effect on the substrate (semiconductor) which is the object to be treated, which is not preferable. In particular, when moisture in the environment is solidified and mixed in during step (II) described below, there is a concern that uniform coagulation of the sublimable substance may be hindered or the effect of suppressing pattern collapsing may be impaired. Therefore, the freezing point of the sublimable substance is preferably 5°C or higher at 1 atm, and 20°C or higher is more preferable.

In addition, non-volatile substances are preferably removed from the sublimable substance by sublimation refining or a separation method such as distillation in advance to reduce the residue after sublimation and drying. From the viewpoint of ease of refining as described above, the boiling point or sublimation point of the sublimable substance is preferably 300°C or lower. Furthermore, for the reason that it is easy to perform step (III) (sublimation of the sublimable substance) described below in a process at room temperature and pressure, the boiling point or sublimation point of the sublimable substance is more preferably 120°C or lower.

As the boiling point or sublimation point of a sublimable substance including a plurality of substances, the boiling point or sublimation point of the component with the highest content (% by mass) among the components included in the sublimable substance is adopted (however, in a case where there are two or more components with the highest content, the boiling point or sublimation point with the highest temperature is used).

For the boiling point of sublimable substances, the initial boiling point as defined in JIS K 2254 (ISO 3405) is used.

In cases where the sublimation point is typically used for a substance, the sublimation point is used.

In addition, for the freezing point of the sublimable substance, the coagulation start temperature determined using DSC under a condition of -10°C/min is used. As the freezing point of a sublimable substance including a plurality of substances, the freezing point of the component with the highest content (% by mass) among the components included in the sublimable substance is used (however, in a case where there are two or more components with the highest content, the higher temperature freezing point is used).

If the temperature range in which the sublimable substance is solid and has a vapor pressure (referred to below as the "sublimation temperature range") is 10°C or higher, even if the composition for drying in a solution state is supplied in an environment of 20°C to 25°C, which is the typical room temperature in a clean room, it is possible to coagulate the sublimable substance using only cooling due to the heat of vaporization of the solvent in the composition for drying, which is more preferable.

In addition, when the sublimation temperature range is in a range of 20°C to 25°C, it is possible to sublimate and remove the sublimable substance without promoting sublimation by heating, decompression, or the like, which is preferable.

As the vapor pressure when defining the sublimation temperature range, 10 Pa or higher is preferable, and 50 Pa or higher is more preferable.

There is no limitation on the type of sublimable substance as long as there is no adverse effect on the substrate (preferably a semiconductor) material and examples thereof include fluorine-containing compounds, naphthalene, paradichlorobenzene, camphor, dimethyl oxalate, neopentyl alcohol, tetrahydrodicyclopentadiene, pyrazine, alkyl amine carbonate, and the like, and fluorine-containing compounds, camphor, dimethyl
oxalate, neopentyl alcohol, tetrahydrodicyclopentadiene, pyrazine, or naphthalene are preferable, and fluorine-containing compounds are even more preferable. The above may be used alone or used in a combination of two or more types.

Examples of fluorine-containing compounds include fluoroalkanes having one or more fluorine atoms with 3 to 6 carbon atoms, fluorocycloalkanes having one or more fluorine atoms with 3 to 6 carbon atoms, fluorobicycloalkanes having one or more fluorine atoms with 10 carbon atoms, tetrafluorotetracyanoquinodimethane, hexafluorocyclotriphosphazene, compounds in which substituents are substituted on the hydrogen atoms of the fluoroalkanes, compounds in which substituents are substituted on the hydrogen atoms of the fluorocycloalkanes, compounds in which substituents are substituted on the hydrogen atoms of the fluorobicycloalkanes, and the like. Examples of the substituents include halogen atoms (preferably chlorine atoms, bromine atoms, and iodine atoms) other than fluorine atoms, hydroxy groups, carboxy groups, oxo groups, alkyl groups, alkyloxy groups, groups formed of combinations thereof, and the like.

According to the present invention, the fluorine-containing compound is at least one compound selected from fluoroalkanes with 3 to 6 carbon atoms, fluorocycloalkanes with 3 to 6 carbon atoms, compounds in which a hydrogen atom of the fluoroalkane is substituted for a chlorine atom, and compounds in which a hydrogen atom of the fluorocycloalkane is substituted for a chlorine atom.

According to the present invention, the sublimable substances for which the sublimation temperature range is in a range of 20 to 25°C include naphthalene, 1,1,2,2,3,3,4-heptafluorocyclopentane (may be referred to below as HFCPA), 1,1-dichlorooctafluorocyclopentane (may be referred to below as DCOFCPA), perfluorocyclohexane (may be referred to below as PFCHA), 1,1,2,2,3,3,4,4-octafluorocyclohexane, camphor, dimethyl oxalate, neopentyl alcohol, tetrahydrodicyclopentadiene, and pyrazine. The above may be used alone or used in a combination of two or more types.

As a sublimable substance, 1,1,2,2,3,3,4-heptafluorocyclopentane (HFCPA) is particularly preferable. HFCPA is generally available and, for example, it is also possible to use commercially available products such as "Zeolola H" manufactured by ZEON Corporation.

The content of the sublimable substance included in the composition for drying of the present invention is not particularly limited, but is preferably 1% by mass to 80% by mass with respect to the total mass of the composition for drying.

When the content of the sublimable substance is 1% by mass or more, there is a tendency for the sublimable substance to coagulate uniformly on the substrate more easily, which is preferable.

On the other hand, when the content of the sublimable substance is 80% by mass or less, there is a tendency to obtain the cooling effect of the heat of vaporization of the solvent more easily and to promote the coagulation of the sublimable substance more easily, which is preferable. In addition, it is easier to keep the time required for sublimation (sublimation time) short, which is preferable.

The lower limit of the content of the sublimable substance is more preferably 5% by mass or more with respect to the total mass of the composition for drying, and particularly preferably 7% by mass or more. In addition, the upper limit of the content of the sublimable substance is more preferably 55% by mass or less with respect to the total mass of the composition for drying, and particularly preferably 53% by mass or less.

The sublimable substance included in the composition for drying of the present invention has a boiling point or sublimation point at 1 atm which is by 5°C or higher than the boiling point of the solvent. This will be discussed in detail in the description of the solvents below.

### <Solvent>

A description will be given of the solvent included in the composition for drying of the present invention.

The composition for drying of the present invention is a solution formed by dissolving the sublimable substance described above in a solvent.

As the solvent used in the present invention, one or two or more which satisfy condition (1) and condition (2) below are included.

Condition (1): At 1 atm, the boiling point is by 5°C or lower than the boiling point or sublimation point of the sublimable substance.

Condition (2): At 1 atm, the boiling point is 75°C or lower.

In the present specification, in a case where a plurality of solvents are included, as the boiling point of each solvent, the azeotropic point is used in a case of an azeotropic solvent. In a case where the solvent is not an azeotropic solvent, the boiling point specified for each solvent is adopted individually.

In the present invention, in step (II) described below, it is necessary to satisfy condition (1) above in order to coagulate the sublimable substance by concentrating the sublimable substance along with the drying of the solvent (volatilization of the solvent).

In the present invention, at 1 atm, the boiling point of condition (2) is preferably by 25°C or lower than the boiling point or sublimation point of the sublimable substance.

In addition, in particular, from the viewpoint of reducing the time required for coagulation in step (II) described below, a solvent satisfying condition (2) above is used in the present invention. That is, when a solvent with a boiling point of 75°C or lower at 1 atm which satisfies condition (2) above is used, it is possible to reduce the time required for coagulation in step (II) described below.

In addition, examples of the effects obtained by using the solvent include the following effects in addition to the effects described above.

By using a solvent, the sublimable substance in the composition for drying is diluted and it is possible to reduce the use amount of the sublimable substance. Due to this, even in a case where expensive sublimable substances such as, for example, fluorine-containing compounds are used, in comparison with using a melt of sublimable substances, the use amount of the sublimable substances is less, which is superior from the viewpoint of economy.

Using a solvent makes it possible to supply the composition for drying as a solution formed by dissolving a sublimable substance in a solvent, thus, coagulation is less easily generated at the supply nozzle tip portion and it is possible to avoid damage to the uneven pattern to which the composition for drying is applied.

The composition for drying including a solvent makes it possible to increase the compatibility with respect to the liquid (remaining liquid) remaining in the uneven pattern in comparison with a case in which a solvent is not included (that is, in a case where a melt of a sublimable substance is used). Due to this, it is possible to replace more efficiently the remaining liquid on the substrate surface with the composition for drying.

Drying (volatilizing) the solvent makes it possible to promote the coagulation of sublimable substances in the composition for drying due to the heat of vaporization at the time of drying. In addition, in such a case, it is possible to make the film thickness of a film (film of solid sublimable substance) formed by the coagulation of a sublimable substance thinner than a film (film of solid sublimable substance) formed by coating a melt formed only of a sublimable substance.

The solvent included in the composition for drying of the present invention is not particularly limited as long as condition (1) and condition (2) described above are satisfied, but when the solvent has compatibility with respect to water, an alcohol having three or fewer carbon atoms (for example, methanol, 1-propanol, 2-propanol, and the like), or mixtures thereof, which are general solvents used in a semiconductor cleaning step, it is possible to efficiently perform replacement of the liquid (remaining liquid) held in at least the recessed portion of the substrate in step (I) described below with the composition for drying of the present invention, which is preferable.

The above "has compatibility" means that, at 25°C and 1 atm, the amount of "solvent used in the cleaning step" which is able to be dissolved in 1 part by mass of the "solvent included in the composition for drying" of the present invention is 0.05 parts by mass or more.

The types of solvents included in the composition for drying of the present invention are not particularly limited as long as condition (1) and condition (2) described above are satisfied, but examples thereof include hydrocarbons which may have at least one of fluorine atoms and chlorine atoms, ethers which may have at least one of fluorine atoms and chlorine atoms, alcohols and esters which may have at least one of fluorine atoms and chlorine atoms, and the like. The above may be used alone or used in a combination of two or more types.

As a solvent, hydrocarbons which may have at least one of fluorine atoms and chlorine atoms, or ethers which may have at least one of fluorine atoms and chlorine atoms are preferable.

Examples of hydrocarbons which may have fluorine atoms include alkanes or cycloalkanes with 4 to 10 carbon atoms, alkenes or cycloalkenes with 4 to 10 carbon atoms, and aromatic hydrocarbons with 6 to 10 carbon atoms, specifically, it is possible to illustrate hexane (boiling point 69°C, vapor pressure 16 kPa), pentane (boiling point 36°C, vapor pressure 53 kPa), 2-methylpentane (boiling point 60°C, vapor pressure 23 kPa), cyclopentane (boiling point 49°C, vapor pressure 45 kPa), 3-methylpentane (boiling point 63°C, vapor pressure 20 kPa), and the like.

In addition, examples include alkanes with 4 to 10 carbon atoms, alkenes with 4 to 10 carbon atoms, and aromatic hydrocarbons with 6 to 10 carbon atoms, which have fluorine atoms and, specifically, it is possible to illustrate perfluorohexane (boiling point 60°C, vapor pressure 27 kPa at 25°C) and the like.

In addition, for example, among alkanes with 1 to 10 carbon atoms, alkenes with 2 to 10 carbon atoms, and aromatic hydrocarbons with 6 to 10 carbon atoms, which have chlorine atoms, examples include hydrocarbons which may have fluorine atoms, specifically, examples thereof include dichloromethane (boiling point 40°C, vapor pressure 47 kPa), trichloromethane (boiling point 62°C, vapor pressure 21 kPa), trichlorofluoromethane (boiling point 24°C, vapor pressure 84 kPa), trans-1-chloro-3,3,3-trifluoropropene (boiling point 18°C, vapor pressure 133 kPa), cis-1-chloro-3,3,3-trifluoropropene (boiling point 39°C, vapor pressure 49 kPa), and the like.

The above boiling point is the value at 1 atm and the above vapor pressure is the value at 20°C, unless otherwise stated. The same applies below.

Examples of ethers which may have fluorine atoms include ethers with 4 to 10 carbon atoms which may have fluorine atoms and specific examples thereof include diethyl ether (boiling point 35°C, vapor pressure 59 kPa), diisopropyl ether (boiling point 69°C, vapor pressure 21 kPa), tert-butyl methyl ether (boiling point 55°C, vapor pressure 27 kPa), tetrahydrofuran (boiling point 65°C, vapor pressure 19 kPa), 1,1,1,3,3,3-hexafluoro-2-methoxypropane(boiling point 61°C, vapor pressure 27 kPa), 1,1,1,2,2,3,3,4,4-nonafluorobutyl methyl ether (boiling point 61°C, vapor pressure 28 kPa at 25°C), and the like.

Specific examples of alcohols which may have fluorine atoms include trifluoroethanol (boiling point 74°C, vapor pressure 10 kPa at 25°C), and the like.

Examples of esters include methyl acetate (boiling point 57°C, vapor pressure 23 kPa), ethyl acetate (boiling point 77°C, vapor pressure 10 kPa), and the like.

Among the solvents described above, from the viewpoint of ease of accessibility, hexane, trans-1-chloro-3,3,3-trifluoropropene, cis-1-chloro-3,3,3-trifluoropropene, diethyl ether, tetrahydrofuran, 1,1,1,3,3,3-hexafluoro-2-methoxypropane, or 1,1,1,2,2,3,3,4,4-nonafluorobutyl methyl ether, 3-methylpentane, cyclopentane, methyl acetate, and ethyl acetate are particularly preferable.

### (Other Solvents)

As long as there is no deviation from the composition range specified in the present invention, in addition to the sublimable substances and the solvents, which are essential components, "other solvents" may be further added to the composition for drying for the purpose of adjusting the wettability or the like for the substrate and/or uneven pattern. Examples include water, hydrocarbons, esters, ethers, ketones, sulfoxide solvents, alcohols, derivatives of polyhydric alcohols, nitrogen-containing compounds, and the like, and solvents which do not fall under the solvents used as essential components described above. Examples of the hydrocarbons described above are toluene, benzene, xylene, pentane, hexane, heptane, octane, nonane, decane, and the like, examples of the esters described above are ethyl acetate, propyl acetate, butyl acetate, ethyl lactate, ethyl acetoacetate, and the like, examples of the ethers described above are diethyl ether, dipropyl ether, dibutyl ether, tert-butyl methyl ether, tetrahydrofuran, dioxane, and the like, examples of the ketones described above are acetone, acetylacetone, methyl ethyl ketone, methyl propyl ketone, methyl butyl ketone, and the like, examples of the sulfoxide solvents described above are dimethyl sulfoxide, and the like, examples of alcohols are methanol, ethanol, 1-propanol, 2-propanol, butanol, 4-methyl-2-pentanol, ethylene glycol, 1,3-propanediol, and the like, examples of derivatives of the polyhydric alcohols described above are diethylene glycol monoethyl ether, ethylene glycol monomethyl ether, ethylene glycol monobutyl ether, propylene glycol monomethyl ether, propylene glycol monoethyl ether, diethylene glycol monoethyl ether acetate, ethylene glycol monomethyl ether acetate, ethylene glycol monobutyl ether acetate, propylene glycol monomethyl ether acetate, propylene glycol monoethyl ether acetate, and the like, examples of the nitrogen-containing compounds described above are formamide, N,N-dimethylformamide, N,N-dimethylacetamide, N-methyl-2-pyrrolidone, pyridine, and the like, and solvents are exemplified which do not correspond to the solvents used as essential components described above, among the above.

The content of the solvent included in the composition for drying of the present invention is not particularly limited, but is preferably 20% by mass to 99% by mass with respect to the total mass of the composition for drying. A solvent content of 20% by mass or more is preferable since there is a tendency to obtain the cooling effect of the heat of vaporization of the solvent more easily and to promote the coagulation of the sublimable substance more easily. On the other hand, when the solvent content is 99% by mass or less, there is a tendency to coagulate the sublimable substance uniformly on the substrate more easily, which is preferable. For the lower limit of the solvent content, 45% by mass or more with respect to the total mass of the composition for drying is more preferable, and 47% by mass or more is particularly preferable. In addition, the upper limit of the solvent content is more preferably 95% by mass or less with respect to the total mass of the composition for drying, and particularly preferably 93% by mass or less.

The composition for drying of the present invention is preferably a liquid (solution) at -15°C to 50°C from the viewpoint of ease of handling (manufacturing, storage, transport, and the like), and more preferably a liquid (solution) at 0°C to 40°C. Furthermore, composition for drying is particularly preferably a liquid at 20°C to 30°C from the viewpoint of simplifying the apparatus configuration, such that no heat retention or heating is necessary for the dispensing mechanism.

### [Method for Manufacturing Substrate having Uneven Pattern on Surface]

The method for manufacturing a substrate having an uneven pattern on a surface of the present invention (also referred to simply as "method for manufacturing a substrate") includes a step (I) in which, a composition for drying which contains a sublimable substance and a solvent whose boiling point at 1 atm is lower than a boiling point or a sublimation point of the sublimable substance by 5°C or more and whose boiling point at 1 atm is 75°C or lower, wherein the sublimable substance is dissolved in the solvent, is supplied, in a solution state, to a recessed portion of an uneven pattern, a step (II) in which the solvent in the recessed portion is dried and the sublimable substance is coagulated, and a step (III) of sublimating the sublimable substance, wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom, or, wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

### <Step (I)>

Step (I) is a step of supplying a composition for drying containing a sublimable substance and a solvent in a solution state to a recessed portion of an uneven pattern provided on the surface of a substrate. The composition for drying is the same as the composition for drying of the present invention described above.

The substrate is not particularly limited, but is preferably a substrate formed of a semiconductor.

Step (I) is preferably performed at 20°C to 30°C. That is, it is preferable to use a composition for drying in a solution state at 20°C to 30°C.

According to the present invention, the sublimable substance is dissolved in the solvent.

The surface of the substrate before the composition for drying is supplied in step (I) usually has a remaining liquid, such as a cleaning liquid used in the cleaning step performed previously, present thereon. Then, the composition for drying supplied in step (I) replaces the remaining liquid. The remaining liquid is not particularly limited, but is usually water or an alcohol having 3 or less carbon atoms (for example, methanol, 1-propanol, 2-propanol, and the like), and, from the viewpoint of ease of replacement by the composition for drying, is preferably at least one selected from methanol, 1-propanol, and 2-propanol.

In step (I), as long as the composition for drying of the present invention is used as the composition for drying and supplied in a solution state, the specific supply method is not particularly limited and it is possible to use any known method.

The composition for drying is supplied to at least part of, or all of, the recessed portions.

### <Step (II)>

Step (II) is a step for drying the solvent in the recessed portion and coagulating the sublimable substance. That is, in step (II), the solvent in the composition for drying (the composition for drying which replaced the remaining liquid of the uneven pattern) supplied to at least part of, or all of, the recessed portions in step (I) above is dried (volatilized) and the sublimable substance in the composition for drying coagulates.

In the present invention, since a solvent with a boiling point of 75°C or lower at 1 atm is used as the solvent, it is possible to reduce the time required for coagulation of the sublimable substance after being supplied to the surface of the uneven pattern and drying at room temperature and pressure (20 to 25°C, 1 atm) is also possible.

In addition, when the freezing point of the sublimable substance is 5°C or higher at 1 atm, extremely low temperatures are not necessary for coagulation and, by drying (volatilizing) the solvent, the coagulation of the sublimable substance is promoted due to the heat of vaporization at that time, which is preferable (it is not necessary to use a special apparatus and it is possible to carry out the above in an environment with room temperature and pressure).

The method of performing step (II) is not particularly limited, but a process at room temperature and pressure is preferable, thus, examples thereof include a method of rotating the substrate to which the composition for drying is supplied, a method of blowing a gas (inert gas is preferable if it is necessary to prevent ignition of the volatile vapor) onto the substrate to which the composition for drying is supplied and exhausting the gas together with the dried (volatilized) solvent, or the like.

### <Step (III)>

Step (III) is a step of sublimating the sublimable substance. That is, in step (III), the sublimable substance is sublimed in order to remove the coagulated body of the sublimable substance (solid film of the sublimable substance) obtained in step (II).

When the boiling point or sublimation point of the sublimable substance is 120°C or lower, it is possible to carry out step (III) in a room temperature and pressure environment, which is preferable.

The temperature at which step (III) is carried out is not particularly limited and the step may be performed at room temperature or may be performed in a heated environment (for example, 30°C to 120°C, preferably 40°C to 80°C). Step (III) performed in a heated environment is also referred to as "step (IIIb)".

The method for carrying out step (III) is not particularly limited, but a process at room temperature and pressure is preferable from the viewpoint of simplifying the apparatus configuration, thus, examples thereof include a method of rotating a substrate on which a coagulated body of a sublimable substance is formed, a method of blowing a gas (inert gas is preferable if it is necessary to prevent ignition of the vaporized sublimable substance) onto a substrate on which a coagulated body of a sublimable substance is formed and exhausting the gas together with the vaporized sublimable substance, or the like.

The method for manufacturing a substrate of the present invention preferably has a step for refining the sublimable substance before step (I). The refining of the sublimable substance is preferably performed by separation methods such as sublimation refining or distillation.

The method for manufacturing a substrate of the present invention makes it possible to manufacture a dried (with no remaining liquid) substrate in which collapsing of the uneven pattern is suppressed while reducing the time required for the sublimable substance to coagulate after being supplied to the surface of the uneven pattern.

FIGs. 1A to 1C are cross-sectional views of steps showing an example of steps for manufacturing a substrate using a composition for drying.

FIG. 1A shows a step of supplying a composition for drying 30 to the surface of a substrate 10 and filling the composition for drying 30 into a recessed portion 24 in an uneven pattern 20, FIG. 1B shows a step of coagulating the composition for drying 30 to form a sublimable film 50, and FIG. 1C shows a step of sublimating a sublimable substance to remove the sublimable film 50.

A detailed description will be given below of the method for manufacturing a substrate.

In the preparation step of the above substrate 10, the following method, which is an example of a method for forming the uneven pattern 20 on the surface of the substrate 10, may be used.

First, resist is coated on the wafer surface, then the resist is exposed through a resist mask, and the exposed resist or unexposed resist is removed to produce a resist having a desired uneven pattern. In addition, it is also possible to obtain a resist having an uneven pattern by pressing a mold with a pattern against a resist. Next, the wafer is etched. At this time, the substrate surface corresponding to the recessed portion of the resist pattern is selectively etched. Finally, when the resist is peeled off, a wafer (the substrate 10) having the uneven pattern 20 on the surface thereof is obtained.

The wafer on which the uneven pattern 20 is formed and the material of the uneven pattern 20 are not particularly limited, and, as wafers, it is possible to use various types of wafers such as silicon wafers, silicon carbide wafers, wafers formed of a plurality of components including silicon elements, sapphire wafers, various compound semiconductor wafers, and plastic wafers. In addition, for the material of the uneven pattern 20, it is possible to use silicon-based materials such as silicon oxide, silicon nitride, polycrystalline silicon, and single-crystal silicon, metal-based materials such as titanium nitride, tungsten, ruthenium, tantalum nitride, and tin, materials combining each of the above, resist (photoresist) materials, and the like.

FIG. 1A is a cross-sectional view of an example of the uneven pattern 20. In the cross-sectional structure (in the substrate thickness direction) in the pattern of the uneven pattern 20, the pattern dimensions of at least one or more of the width and height thereof, or, in the three-dimensional structure (three-dimensional coordinates of XYZ) in the pattern of the uneven pattern 20, the pattern dimensions of at least one or more of the width (length in the X-axis direction), height (length in the Y-axis direction), and depth (length in the Z-axis direction) thereof may be 30 nm or less, 20 nm or less, or 10 nm or less, for example. Even in a case where the substrate 10 having the fine uneven pattern 20 is used, using the composition for drying of the present embodiment makes it possible to reduce the pattern collapsing ratio.

Such a composition for drying is suitable, for example, for use in treating the substrate 10 having the uneven pattern 20 with a pattern dimension of 30 nm or less, preferably 20 nm or less.

The lower limit of the aspect ratio of a convex portion 22 may be 3 or more, 5 or more, or 10 or more, for example. It is possible to suppress pattern collapsing even in the uneven pattern 20 having the convex portion 22 with a fragile structure.

On the other hand, the upper limit of the aspect ratio of the convex portion 22 is not particularly limited and may be 100 or less.

The aspect ratio of the convex portion 22 is expressed as the value obtained by dividing the height of the convex portion 22 by the width of the convex portion 22.

After the formation of the uneven pattern 20, the surface of the substrate 10 is cleaned using a cleaning liquid such as water or an organic solvent (cleaning step).

After the cleaning step, as shown in FIG. 1A, it is preferable to supply the composition for drying, which is a liquid in an environment of 20°C to 30°C, to the uneven pattern 20 formed on the surface of the substrate 10. At this time, the composition for drying may be supplied so as to fill part of, or all of, the recessed portion 24 of the uneven pattern 20 (filling step) . The supply may be carried out, for example, in an environment of 20°C to 30°C.

It is possible to use a known method in the method for supplying the composition for drying, for example, a single wafer method represented by a spin method, in which a composition is supplied near the center of rotation while wafers are held almost horizontally one by one and rotated, a cleaning liquid or the like retained in the uneven pattern of the wafers is replaced, and the composition is filled therein, or a batch method, in which a plurality of wafers are immersed in a composition tank, the cleaning liquid or the like retained in the uneven pattern of the wafers is replaced, and the composition is filled therein.

After the cleaning step, the used cleaning liquid remains on the surface of the substrate 10. By selecting a type of cleaning liquid which dissolves in the composition for drying as the cleaning liquid, it is possible to replace the remaining cleaning liquid with the composition for drying comparatively easily. Therefore, as the cleaning liquid, it is usually preferable to use at least one selected from alcohols with three or fewer carbon atoms, such as methanol, 1-propanol, and 2-propanol.

The sublimable substances used in the composition for drying may be refined in advance. For refining of the sublimable substance, separation methods such as sublimation refining or distillation are used.

After the filling step, as shown in FIG. 1B, the sublimable substances in the composition for drying 30 are coagulated and the sublimable film 50 including the coagulated body of the sublimable substance is formed on the uneven pattern 20 (coagulation step). The sublimable film 50 filled inside the recessed portion 24 of the uneven pattern 20 makes it possible to suppress pattern collapsing of the uneven pattern 20.

In the coagulation step, the solid sublimable substance may be precipitated by cooling, or the solvent may be evaporated by heating or applying suitable environmental conditions and the solid sublimable substance may be precipitated by the heat of vaporization.

In the present embodiment, it is also possible to perform the volatilization (drying) of the solvent, for example, under room temperature and pressure (20°C to 25°C, 1 atm), by appropriately selecting the solvent used for the composition for drying as described above.

In addition, by setting the lower limit of the freezing point of the sublimable substance to the lower limit value described above or more, extreme cooling becomes unnecessary and it is possible to coagulate the sublimable substance using the heat of vaporization of the solvent.

When the coagulation step is performed under room temperature and pressure, as necessary, the volatilization of the solvent may be promoted, for example, by a method of rotating the substrate 10 or by blowing an inert gas on the substrate 10.

After the coagulation step, as shown in FIG. 1C, the solid sublimable substance is sublimated to remove the sublimable film 50 on the uneven pattern 20 (removal step).

It is possible to appropriately select the method for sublimating the sublimable substance according to the boiling point of the sublimable substance; however, for example, in a case where the boiling point is comparatively low, sublimation may be carried out under room temperature and pressure, or, as necessary, heating or decompression may be performed.

The object of the manufacturing method shown in Figs. 1A to 1C is wafer patterns, but the present invention is not limited thereto. The object of the method for manufacturing a substrate of the present embodiment is resist patterns and it is also possible to suppress resist pattern collapsing by using the composition for drying of the present invention in the cleaning and drying steps thereof.

A manufacturing method in which the supply step described above is carried out after the cleaning step was described; however, the method is not limited thereto and may be carried out after various treatments carried out with respect to the uneven pattern 20. For example, the supply step may be performed after a chemical solution for forming a water-repellent protective film is treated on the uneven pattern 20.

In addition to the above steps, one or two or more combinations of known treatments may be used in the substrate manufacturing method. For example, a surface treatment such as a plasma treatment may be performed after the removal step described above.

Embodiments of the present invention were described above; however, these are examples of the present invention and it is possible to adopt various configurations other than the above. In addition, the present invention is not limited to the embodiments described above and the present invention includes modifications, improvements, and the like in a range in which it is possible to achieve the object of the present invention.

Examples of reference embodiments are described below.
<1>
   A composition for drying an uneven pattern containing a sublimable substance and a solvent, in which the boiling point of the solvent at 1 atm is lower than the boiling point or sublimation point of the sublimable substance by 5°C or more, and the boiling point of the solvent at 1 atm is 75°C or lower.
<2>
   The composition for drying an uneven pattern according to <1>, in which the freezing point of the sublimable substance is 5°C or higher at 1 atm.
<3>
   The composition for drying an uneven pattern according to <1> or <2>, in which the boiling point or sublimation point of the sublimable substance is 300°C or lower.
<4>
   The composition for drying an uneven pattern according to any one of <1> to <3>, in which the sublimable substance is at least one compound selected from fluoroalkanes with 3 to 6 carbon atoms, fluorocycloalkanes with 3 to 6 carbon atoms, compounds in which a hydrogen atom of the fluoroalkane is replaced by a chlorine atom, and compounds in which a hydrogen atom of the fluorocycloalkane is replaced by a chlorine atom.
<5>
   The composition for drying an uneven pattern according to any one of <1> to <3>, in which the sublimable substance is naphthalene, 1,1,2,2,3,3,4-heptafluorocyclopentane, 1,1-dichlorooctafluorocyclopentane, 1,1,2,2,3,3,4,4-octafluorocyclohexane, or perfluorocyclohexane.
<6>
   The composition for drying an uneven pattern according to <5>, in which the sublimable substance is 1,1,2,2,3,3,4-heptafluorocyclopentane.
<7>
   The composition for drying an uneven pattern according to any one of <1> to <6>, in which the content of the sublimable substance is 5% by mass to 55% by mass with respect to the total mass of the composition for drying an uneven pattern.
<8>
   The composition for drying an uneven pattern according to any one of <1> to <7>, in which the solvent is at least one selected from hydrocarbons which may have at least one of fluorine atoms and chlorine atoms, ethers which may have at least one of fluorine atoms and chlorine atoms, and alcohols which may have at least one of fluorine atoms and chlorine atoms.
<9>
   The composition for drying an uneven pattern according to <8>, in which the solvent is hexane, trans-1-chloro-3,3,3-trifluoropropene, cis-1-chloro-3,3,3-trifluoropropene, diethyl ether, tetrahydrofuran, 1,1,1,3,3,3-hexafluoro-2-methoxypropane, or 1,1,1,2,2,3,3,4,4-nonafluorobutyl methyl ether.
<10>
   A method for manufacturing a substrate having an uneven pattern on a surface, the method including a step (I) in which, a composition for drying which contains a sublimable substance and a solvent is supplied, in a solution state, to a recessed portion of an uneven pattern, a step (II) in which the solvent in the recessed portion is dried and the sublimable substance is coagulated, and a step (III) of sublimating the sublimable substance, in which the boiling point of the solvent at 1 atm is 5°C or more lower than the boiling point or sublimation point of the sublimable substance, and the boiling point of the solvent at 1 atm is 75°C or lower.
<11>The method for manufacturing a substrate having an uneven pattern on a surface according to <10>, in which a step of refining the sublimable substance is performed before step (i).

### Examples (Example 1)

2.0 g of 1,1,2,2,3,3,4-heptafluorocyclopentane (HFCPA) was used as a sublimable substance. As a solvent, cis-1-chloro-3,3,3-trifluoropropene (1233Z) was used and dissolved and diluted to a total of 10.0 g. This solution was used as the composition for drying. As HFCPA, Zeolola H manufactured by ZEON Corporation was used.

A silicon substrate on which an uneven pattern having a plurality of approximately cylindrical convex portions having an aspect ratio of 22 and a pattern width of 19 nm at a pitch of 90 nm (the total distance between the width of the convex portions and the adjacent interval of the convex portions) in cross-sectional view was formed on the surface was cut out to dimensions of 1 cm x 1.5 cm and used as an evaluation sample. The evaluation sample was dry cleaned by UV/O₃ irradiation in advance and then used. The evaluation sample was placed in a spin coater and 2-propanol was supplied in a state in which the liquid (2-propanol) was held in the recessed portion of the pattern. Next, the 2-propanol (remaining liquid) was replaced by the composition for drying by dropping the composition for drying therein in a solution state (step (I)). Next, the evaluation sample was rotated in a spin coater and the formation of a coagulated body (solid film of sublimable substance) was confirmed visually (step (II)). The rotation was continued until the disappearance of the coagulated body was confirmed visually (step (III)). Steps (I) to (III) were performed in a nitrogen atmosphere of 23°C to 24°C at 1 atm.

The pattern collapsing prevention performance was evaluated by observing the evaluation sample obtained after step (III) with a scanning electron microscope (SEM) (SU8010, manufactured by Hitachi High-Technologies Corporation). The results are shown in Table 1 below. The "pattern collapsing ratio" was calculated by taking an electron microscope image (secondary electron image) of the center of the evaluation sample using an SEM at a magnification with 500 to 600 convex portions in the field of view, counting the convex portions which were collapsed in the image, and using the percentage of the ratio of the number of convex portions in the field of view. The values were rounded to the nearest 10 by rounding in accordance with JIS Z 8401.

### (Examples 2 to 15)

HFCPA was used as the sublimable substance in the same manner as in Example 1, and the concentration and the like of the solvent and the sublimable substance were changed as shown in Table 1 below to carry out the evaluation sample preparation and evaluation in the same manner as in Example 1. The results are shown in Table 1 below.

### (Comparative Examples 1 to 10)

HFCPA was used as the sublimable substance as in Example 1, the concentrations of the solvent and sublimable substance were changed as shown in Table 2 below, and the evaluation sample preparation and evaluation were performed as in Example 1. The results are shown in Table 2 below.

In Comparative Example 1, no sublimable substance was used and only solvent was used as the composition for drying. In addition, In Comparative Example 2, no solvent was used and a melt of a sublimable substance was used as the composition for drying. In Comparative Examples 3 to 9, compositions which did not satisfy both of condition (1) "the boiling point of the solvent is by 5°C or lower than the boiling point or sublimation point of the sublimable substance at 1 atm" and condition (2) "the boiling point of the solvent is 75°C or lower at 1 atm" were used as the composition for drying. In Comparative Example 10, a composition which satisfied condition (1) but did not satisfy condition (2) was used as the composition for drying.

### (Example 16, Comparative Examples 11 to 15)

Naphthalene was used as the sublimable substance, the concentration and the like of the solvent and sublimable substance were changed as shown in Table 3 below, step (I) and step (II) were performed in the same manner as in Example 1, and the evaluation sample was moved onto a hot plate at 50°C and then heated in a stationary state until the disappearance of the coagulated body was confirmed visually (step (IIIb)). Steps (I) and (II) were performed at 23°C to 24°C and in a nitrogen atmosphere of 1 atm and step (IIIb) was performed at 50°C and in a nitrogen atmosphere of 1 atm. The evaluation samples after the completion of step (IIIb) were evaluated in the same manner as in Example 1 and the results are shown in Table 3 below.

In Comparative Example 11, no sublimable substance was used and only solvent was used as the composition for drying. In Comparative Example 12, no solvent was used and a melt of a sublimable substance was used as the composition for drying. In Comparative Examples 13 to 15, compositions which satisfied condition (1) but did not satisfy condition (2) were used as the composition for dryings.

### (Examples 17 to 21, Comparative Example 16)

DCOFCPA was used as a sublimable substance, the concentration and the like of the solvent and sublimable substance were changed as shown in Table 4 below, and the evaluation sample preparation and evaluation were performed in the same manner as in Example 1. The results are shown in Table 4 below. In Comparative Example 16, a composition which did not satisfy either of condition (1) and condition (2) was used as the composition for drying.

### (Examples 22 to 37, Comparative Example 17)

Compositions for drying were prepared by mixing a sublimating agent (sublimable substance) with a solvent to the sublimating agent concentrations (% by mass) listed in Table 7. The evaluation sample preparation and evaluation were performed in the same manner as in Example 1.

### (Examples 38 to 40)

Compositions for drying were prepared by mixing a sublimating agent 1 and a sublimating agent 2 (sublimable substances) with a solvent 1 and/or a solvent 2 to the mixing ratios (% by mass) listed in Table 8. The evaluation sample preparation and evaluation were performed in the same manner as in Example 1.

In Tables 1 to 4, 7, and 8 below, the type of solvent used in each of the Examples and Comparative Examples, the difference between the boiling point or sublimation point of the sublimable substance and the boiling point of the solvent, the concentration of the sublimable substance in the composition for drying, the substitutability (amount of composition for drying required for step (I)), the coagulation time (time required for step (II)), the sublimation time (time required for step (III) or step (IIIb)), and the pattern collapsing ratio are listed.

The abbreviations, boiling points and vapor pressures of the solvents are listed in Table 5 below.

The abbreviations, freezing points, boiling points, and vapor pressures of the sublimable substances are listed in Table 6 below.

The sublimable substances in all the Examples and Comparative Examples were refined in advance.

**Table 1: Using HFCPA as sublimable substance**

| No. | Solven t | Difference between boiling point or sublimatio n point of sublimable substance and solvent boiling point (°C) | Sublimable substance concentratio n (% by mass) | Coagulatio n (Film formed) [yes/no] | Substitutabilit y (Composition amount required in step (I)) [g] (lower is better)] | Coagulatio n time (time required in step (II)) [seconds] | Sublimatio n time (time required in step (III)) [seconds] | Pattern collapsin g ratio [%] (lower value is better) | Note s |
|---|---|---|---|---|---|---|---|---|---|
| Exampl e 1 | 1233Z | 44 | 20 | Yes | 1 | 30 | 20 | 20 | |
| Exampl e 2 | 1233Z | 44 | 30 | Yes | 1 | 40 | 50 | 10 | |
| Exampl e 3 | 1233Z | 44 | 50 | Yes | 1 | 30 | 80 | 20 | |
| Exampl e 4 | 1233Z | 44 | 80 | Yes | 1 | 40 | 260 | 10 | |
| Exampl e 5 | 1233E | 65 | 10 | Yes | 1 | 10 | 20 | 10 | |
| Exampl e 6 | 1233E | 65 | 20 | Yes | 1 | 10 | 30 | 10 | |
| Exampl e 7 | 1233E | 65 | 30 | Yes | 1 | 20 | 60 | 10 | |
| Exampl e 8 | Et2O | 48 | 50 | Yes | 1.5 | 40 | 40 | 20 | |
| Exampl e 9 | 356mmz | 22 | 20 | Yes | 1 | 30 | 20 | 0 | |
| Exampl e 10 | 356mmz | 22 | 50 | Yes | 1 | 50 | 30 | 10 | |
| Exampl e 11 | Hexane | 14 | 80 | Yes | 2.5 | 10 | 140 | 10 | |
| Exampl e 12 | N71 | 22 | 20 | Yes | 1 | 30 | 20 | 0 | |
| Exampl e 13 | N71 | 22 | 30 | Yes | 1 | 40 | 20 | 0 | |
| Exampl e 14 | N71 | 22 | 50 | Yes | 1 | 50 | 40 | 0 | |
| Exampl e 15 | N71 | 22 | 80 | Yes | 1 | 40 | 200 | 0 | |

**Table 2: Using HFCPA as sublimable substance**

| No. | Solvent | Differenc e between boiling point or sublimati on point of sublimabl e substance and solvent boiling point (°C) | Sublimable substance concentrati on (% by mass) | Coagulati on (Film formed) [yes/no] | Substitutabil ity (Composition amount required in step (I)) [g] (lower is better)] | Coagulati on time (time required in step (II)) [seconds] | Sublimati on time (time required in step (III)) [seconds] | Pattern collapsi ng ratio [%] (lower value is better) | Notes |
|---|---|---|---|---|---|---|---|---|---|
| Comparati ve Example 1 | 1233Z | | 0 | No | | (None) | 10 (drying time) | 100 | Total collapse |
| Comparati ve Example 2 | (None) | | 100 | Yes | 3 | 40 | 360 | 0 | Large amount of consumpti on of sublimabl e substance coagulate d at nozzle tip |
| Comparati ve Example 3 | Toluene | -28 | 20 | No | | | | 100 | Total collapse |
| Comparati ve Example 4 | Toluene | -28 | 50 | No | | | | 100 | Total collapse |
| Comparati ve Example 5 | Toluene | -28 | 80 | No | | | | 100 | Total collapse |
| Comparati ve Example 6 | Dimethy 1 carbona te | -7 | 50 | No | | | | 100 | Total collapse |
| Comparati ve Example 7 | Dimethy 1 carbona te | -7 | 80 | No | | | | 100 | Total collapse |
| Comparati ve Example 8 | DCE | -1 | 50 | No | | | | 100 | Total collapse |
| Comparati ve Example 9 | IPA | 1 | 50 | No | | | | 100 | Total collapse |
| Comparati ve Example 10 | N72 | 7 | 80 | Yes | 1.5 | 110 | 180 | 20 | |

**Table 3: Using naphthalene as sublimable substance**

| No. | Solven t | Differenc e between boiling point or sublimati on point of sublimabl e substance and solvent boiling point (°C) | Sublimable substance concentrati on (% by mass) | Coagulati on (Film formed) [yes/no] | Substitutabil ity (Composition amount required in step (I)) [g] (lower is better)] | Coagulati on time (time required in step (II)) [seconds] | Sublimati on time (time required in step (IIIb)) [seconds] | Pattern collapsi ng ratio [%] (lower value is better) | Notes |
|---|---|---|---|---|---|---|---|---|---|
| Example 16 | THF | 153 | 30 | Yes | 1 | 30 | 300 | 10 | |
| Comparati ve Example 11 | THF | | 0 | No | | (None) | 120 (Drying time) | 100 | Total collapse |
| Comparati ve Example 12 | (None) | | 100 | Yes | 5 | 30 | 1200 | 10 | Large amount of consumpti on of sublimabl e substance coagulate d at nozzle tip |
| Comparati ve Example 13 | DCE | 134 | 30 | Yes | 2 | 60 | 300 | 0 | |
| Comparati ve Example 14 | Toluen e | 107 | 30 | Yes | 3 | 70 | 400 | 10 | |
| Comparati ve Example 15 | TMB | 54 | 30 | Yes | 3 | 300 | 300 | 0 | |

**Table 4: Using DCOFCPA as sublimable substance**

| No. | Solven t | Differenc e between boiling point or sublimation point of sublimabl e substance and solvent boiling point (°C) | Sublimable substance concentrati on (% by mass) | Coagulati on (Film formed) [yes/no] | Substitutabili ty (Composition amount required in step (I)) [g] (lower is better)] | Coagulati on time (time required in step (II)) [seconds] | Sublimati on time (time required in step (III)) [seconds] | Pattern collapsi ng ratio [%] (lower value is better) | Notes |
|---|---|---|---|---|---|---|---|---|---|
| Example 17 | 1233Z | 46 | 50 | Yes | 1 | 10 | 40 | 10 | |
| Example 18 | 1233Z | 46 | 80 | Yes | 1 | 10 | 110 | 0 | |
| Example 19 | Et2O | 50 | 50 | Yes | 1.5 | 10 | 50 | 10 | |
| Example 20 | 356mmz | 24 | 50 | Yes | 1 | 40 | 30 | 10 | |
| Example 21 | N71 | 24 | 50 | Yes | 1 | 50 | 30 | 0 | |
| Comparati ve Example 16 | IPA | 3 | 20 | No | | | | 100 | Total collaps e |

**Table 5**

| Solvent Chemical name | Abbreviation | Boiling point (°C) | Vapor pressure (kPa) |
|---|---|---|---|
| trans-1-chloro-3,3,3-trifluoropropene | 1233E | 18 | 133 |
| Diethylether | Et2O | 35 | 59 |
| cis-1-chloro-3,3,3-trifluoropropene | 1233Z | 39 | 49 |
| 1,1,1,3,3,3-hexafluoro-2-methoxypropane | 356mmz | 61 | 27 (25°C) |
| 1,2-dichloroethane | DCE | 84 | 11 |
| Hexane | | 69 | 16 |
| Toluene | | 111 | 4 (25°C) |
| Tetrahydrofuran | THF | 65 | 19 |
| Dimethyl carbonate | | 90 | 7 (25°C) |
| 1,1,1,2,2,3,3,4,4-nonafluorobutyl methyl ether | N71 | 61 | 28 (25°C) |
| 1,1,1,2,2,3,3,4,4-nonafluorobutyl ethyl ether | N72 | 76 | 16 (25°C) |
| 1,3,5-triethylbenzene | TMB | 164 | 0.3 |
| 2-propanol | IPA | 82 | 4 |
| Methyl acetate | | 57 | 23 |
| 3-methylpentane | | 63 | 20 |
| Dichloropentane | | 49 | 53 |
| propyleneglycol monomethylether acetate | PGMEA | 146 | 4 |

Unless otherwise stated, vapor pressure is a value at 20C. Boiling point is a value at normal atmospheric pressure.

**Table 6**

| Sublimable substance Chemical name | Abbreviatio n | Freezin g point (°C) | Boilin g point (°C) | Vapor pressur e (kPa) |
|---|---|---|---|---|
| 1,1,2,2,3,3,4-heptafluorocyclopentan e | HFCPA | 21 | 83 | 8 |
| 1,1-dichlorooctafluorocyclopentane | DCOFCPA | 58 | 85 | 8 |
| Naphthalene | | 80 | 218 | 0.01 (25°C) |
| Camphor | | 175 | 204 | 0.03 |
| Dimethyl oxalate | | 54 | 164 | 0.05 |
| Neopentyl alcohol | | 54 | 114 | 1 |
| endo-tetrahydrodicyclopentadiene | | 74 | 195 | 0.2 |
| Pyrazine | | 47 | 115 | 5 |

**Table 7**

| | Solve nt boili ng point [C] | Sublimat ing agent boiling point [C] | Boiling point differenc e (Sublimat ing agent - Solvent) [C] | Sublimatin g agent concentrat ion [% by mass] | Coagulat ion time [seconds ] | Pattern collaps ing ratio [%] | Solvent | Sublimating agent |
|---|---|---|---|---|---|---|---|---|
| Example 22 | 61 | 204 | 143 | 1 | 10 | 30 | N71 | (±) Camphor |
| Example 23 | 39 | 204 | 165 | 2 | 10 | 10 | 1233Z | (±) Camphor |
| Example 24 | 49 | 204 | 155 | 1 | 10 | 10 | Cyclopentan e | (±) Camphor |
| Comparat ive Example 17 | 146 | 204 | 58 | 1 | No coagulat ion | 100 | PGMEA | (±) Camphor |
| Example 25 | 39 | 164 | 125 | 1 | 30 | 30 | 1233Z | Dimethyl oxalate |
| Example 26 | 57 | 164 | 107 | 1 | 50 | 30 | Methyl acetate | Dimethyl oxalate |
| Example 27 | 39 | 114 | 75 | 30 | 10 | 10 | 1233Z | Neopentyl alcohol |
| Example 28 | 39 | 114 | 75 | 20 | 10 | 10 | 1233Z | Neopentyl alcohol |
| Example 29 | 39 | 114 | 75 | 10 | 10 | 10 | 1233Z | Neopentyl alcohol |
| Example 30 | 39 | 114 | 75 | 5 | 10 | 10 | 1233Z | Neopentyl alcohol |
| Example 31 | 39 | 114 | 75 | 3 | 10 | 10 | 1233Z | Neopentyl alcohol |
| Example 32 | 61 | 114 | 53 | 10 | 10 | 10 | N71 | Neopentyl alcohol |
| Example 33 | 63 | 195 | 132 | 4 | 30 | 10 | 3-methylpen tane | endo-tetrahydrodicyclopen tadiene |
| Example 34 | 49 | 195 | 146 | 4 | 30 | 10 | Cyclopentan e | endo-tetrahydrodicyclopen tadiene |
| Example 35 | 39 | 195 | 156 | 4 | 10 | 10 | 1233Z | endo-tetrahydrodicyclopen tadiene |
| Example 36 | 68 | 195 | 127 | 4 | 20 | 10 | Hexane | endo-tetrahydrodicyclopen tadiene |
| Example 37 | 39 | 115 | 76 | 10 | 10 | 80 | 1233Z | Pyrazine |

**Table 8**

| | Sublimating agent 1 | Sublimatin g agent 2 | Solven t 1 | Solven t 2 | Mixing ratio | | | | Coagulatio n time | Pattern collapsin g ratio |
|---|---|---|---|---|---|---|---|---|---|---|
| | Name | Name | Name | Name | Sublimating agent 1 | Sublimatin g agent 2 | Solven t 1 | Solven t 2 | | |
| | | | | | [% by mass] | [% by mass] | [% by mass] | [% by mass] | [seconds] | [%] |
| Exampl e 38 | HFCPA | DCOFCPA | 1233Z | - | 20 | 10 | 70 | - | 10 | 30 |
| Exampl e 39 | HFCPA | - | 1233Z | 1233E | 25 | - | 50 | 25 | 20 | 10 |
| Exampl e 40 | HFCPA | DCOFCPA | 1233Z | 1233E | 10 | 10 | 30 | 50 | 10 | 10 |

## Claims

1. A composition for drying an uneven pattern comprising:
a sublimable substance; and
a solvent whose boiling point at 1 atm is lower than a boiling point or a sublimation point of the sublimable substance by 5°C or more and whose boiling point at 1 atm is 75°C or lower,
wherein the sublimable substance is dissolved in the solvent,
wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom,
or
wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

2. The composition for drying an uneven pattern according to claim 1,
wherein a freezing point of the sublimable substance at 1 atm is 5°C or higher.

3. The composition for drying an uneven pattern according to claim 1 or 2,
wherein the boiling point or the sublimation point of the sublimable substance is 300°C or lower.

4. The composition for drying an uneven pattern according to claim 1,
wherein the sublimable substance includes 1,1,2,2,3,3,4-heptafluorocyclopentane.

5. The composition for drying an uneven pattern according to any one of claims 1 to 4,
wherein a content of the sublimable substance is 1% by mass or more and 80% by mass or less with respect to a total mass of the composition for drying an uneven pattern.

6. The composition for drying an uneven pattern according to any one of claims 1 to 5,
wherein the solvent includes one or two or more selected from the group consisting of hydrocarbons which may have at least one of fluorine atoms and chlorine atoms, ethers which may have at least one of fluorine atoms and chlorine atoms, alcohols which may have at least one of fluorine atoms and chlorine atoms, and esters.

7. The composition for drying an uneven pattern according to claim 6,
wherein the solvent includes one or two or more selected from the group consisting of hexane, trans-1-chloro-3,3,3-trifluoropropene, cis-1-chloro-3,3,3-trifluoropropene, diethyl ether, tetrahydrofuran, 1,1,1,3,3,3-hexafluoro-2-methoxypropane, 1,1,1,2,2,3,3,4,4-nonafluorobutyl methyl ether, 3-methyl pentane, cyclopentane, and methyl acetate.

8. The composition for drying an uneven pattern according to any one of claims 1 to 7,
wherein the composition is used for treating a substrate having an uneven pattern with a pattern dimension of 30 nm or less.

9. The composition for drying an uneven pattern according to claim 8,
wherein the composition is used for treating the substrate having an uneven pattern with a pattern dimension of 20 nm or less.

10. A method for manufacturing a substrate having an uneven pattern on a surface, the method comprising:
a step (I) in which, a composition for drying which contains a sublimable substance and a solvent whose boiling point at 1 atm is lower than a boiling point or a sublimation point of the sublimable substance by 5°C or more and whose boiling point at 1 atm is 75°C or lower, wherein the sublimable substance is dissolved in the solvent, is supplied, in a solution state, to a recessed portion of the uneven pattern;
a step (II) in which the solvent in the recessed portion is dried and the sublimable substance is coagulated; and
a step (III) of sublimating the sublimable substance,
wherein the sublimable substance includes one or two or more selected from the group consisting of a fluoroalkane having 3 to 6 carbon atoms, a fluorocycloalkane having 3 to 6 carbon atoms, a compound in which a hydrogen atom of the fluoroalkane is replaced by a chlorine atom, and a compound in which a hydrogen atom of the fluorocycloalkane is replaced by a chlorine atom,
or
wherein the sublimable substance includes one or two or more selected from the group consisting of naphthalene, 1,1,2,2,3,3,4-heptafluorocyclopentane, 1,1-dichlorooctafluorocyclopentane, 1,1,2,2,3,3,4,4-octafluorocyclohexane, perfluorocyclohexane, camphor, dimethyl oxalate, neopentyl alcohol, tetrahydrodicyclopentadiene, and pyrazine.

11. The method for manufacturing a substrate having an uneven pattern on a surface according to claim 10, further comprising:
a step of purifying the sublimable substance before step (I).

12. The method for manufacturing a substrate having an uneven pattern on a surface according to claim 10 or 11,
wherein the substrate has the uneven pattern with a pattern dimension of 30 nm or less on the surface.

13. The method for manufacturing a substrate having an uneven pattern on a surface according to claim 12,
wherein the substrate has the uneven pattern with a pattern dimension of 20 nm or less on the surface.

## Patentansprüche

1. Zusammensetzung zum Trocknen eines unebenen Musters, umfassend:
eine sublimierbare Substanz; und
ein Lösungsmittel, dessen Siedepunkt bei 1 atm um 5°C oder mehr niedriger ist als ein Siedepunkt oder ein Sublimationspunkt der sublimierbaren Substanz, und dessen Siedepunkt bei 1 atm 75°C oder niedriger ist,
wobei die sublimierbare Substanz in dem Lösungsmittel gelöst ist,
wobei die sublimierbare Substanz eines oder zwei oder mehr umfasst, welche ausgewählt sind aus der Gruppe bestehend aus einem Fluoralkan mit 3 bis 6 Kohlenstoffatomen, einem Fluorcycloalkan mit 3 bis 6 Kohlenstoffatomen, einer Verbindung, in der ein Wasserstoffatom des Fluoralkans durch ein Chloratom ersetzt ist, und einer Verbindung, in der ein Wasserstoffatom des Fluorcycloalkans durch ein Chloratom ersetzt ist,
oder
wobei die sublimierbare Substanz eines oder zwei oder mehr umfasst, welche ausgewählt sind aus der Gruppe bestehend aus Naphthalin, 1,1,2,2,3,3,4-Heptafluorcyclopentan, 1,1-Dichloroctafluorcyclopentan, 1,1,2,2,3,3,4,4-Octafluorcyclohexan, Perfluorcyclohexan, Campher, Dimethyloxalat, Neopentylalkohol, Tetrahydrodicyclopentadien und Pyrazin.

2. Zusammensetzung zum Trocknen eines unebenen Musters nach Anspruch 1,
wobei ein Gefrierpunkt der sublimierbaren Substanz bei 1 atm 5°C oder höher ist.

3. Zusammensetzung zum Trocknen eines unebenen Musters nach Anspruch 1 oder 2,
wobei der Siedepunkt oder der Sublimationspunkt der sublimierbaren Substanz 300°C oder niedriger ist.

4. Zusammensetzung zum Trocknen eines unebenen Musters nach Anspruch 1,
wobei die sublimierbare Substanz 1,1,2,2,3,3,4-Heptafluorcyclopentan umfasst.

5. Zusammensetzung zum Trocknen eines unebenen Musters nach einem der Ansprüche 1 bis 4,
wobei ein Gehalt der sublimierbaren Substanz 1 Massen-% oder mehr und 80 Massen-% oder weniger beträgt, bezogen auf eine gesamte Masse der Zusammensetzung zum Trocknen eines unebenen Musters.

6. Zusammensetzung zum Trocknen eines unebenen Musters nach einem der Ansprüche 1 bis 5,
wobei das Lösungsmittel eines oder zwei oder mehr umfasst, welche ausgewählt sind aus der Gruppe bestehend aus Kohlenwasserstoffen, die mindestens eines von Fluoratomen und Chloratomen aufweisen können, Ethern, die mindestens eines von Fluoratomen und Chloratomen aufweisen können, Alkoholen, die mindestens eines von Fluoratomen und Chloratomen aufweisen können, und Estern.

7. Zusammensetzung zum Trocknen eines unebenen Musters nach Anspruch 6,
wobei das Lösungsmittel eines oder zwei oder mehr umfasst, welche ausgewählt sind aus der Gruppe bestehend aus Hexan, trans-1-Chlor-3,3,3-trifluorpropen, cis-1-Chlor-3,3,3-trifluorpropen, Diethylether, Tetrahydrofuran, 1,1,1,3,3,3-Hexafluor-2-methoxypropan, 1,1,1,2,2,3,3,4,4,-Nonafluorbutylmethylether, 3-Methylpentan, Cyclopentan und Methylacetat.

8. Zusammensetzung zum Trocknen eines unebenen Musters nach einem der Ansprüche 1 bis 7,
wobei die Zusammensetzung zum Behandeln eines Substrats verwendet wird, das ein unebenes Muster mit einer Musterdimension von 30 nm oder weniger aufweist.

9. Zusammensetzung zum Trocknen eines unebenen Musters nach Anspruch 8,
wobei die Zusammensetzung zum Behandeln des Substrats verwendet wird, das ein unebenes Muster mit einer Musterdimension von 20 nm oder weniger aufweist.

10. Verfahren zum Herstellen eines Substrats, das ein unebenes Muster auf einer Oberfläche aufweist, wobei das Verfahren umfasst:
einen Schritt (I), in dem eine Zusammensetzung zum Trocknen, die eine sublimierbare Substanz und ein Lösungsmittel enthält, dessen Siedepunkt bei 1 atm um 5°C oder mehr niedriger ist als ein Siedepunkt oder ein Sublimationspunkt der sublimierbaren Substanz, und dessen Siedepunkt bei 1 atm 75°C oder niedriger ist, wobei die sublimierbare Substanz in dem Lösungsmittel gelöst ist, in einem Lösungszustand einem vertieften Abschnitt des unebenen Musters zugeführt wird;
einen Schritt (II), in dem das Lösungsmittel in dem vertieften Abschnitt getrocknet wird und die sublimierbare Substanz koaguliert wird; und
einen Schritt (III) des Sublimierens der sublimierbaren Substanz,
wobei die sublimierbare Substanz eines oder zwei oder mehr umfasst, welche ausgewählt sind aus der Gruppe bestehend aus einem Fluoralkan mit 3 bis 6 Kohlenstoffatomen, einem Fluorcycloalkan mit 3 bis 6 Kohlenstoffatomen, einer Verbindung, in der ein Wasserstoffatom des Fluoralkans durch ein Chloratom ersetzt ist, und einer Verbindung, in der ein Wasserstoffatom des Fluorcycloalkans durch ein Chloratom ersetzt ist,
oder
wobei die sublimierbare Substanz eines oder zwei oder mehr umfasst, welche ausgewählt sind aus der Gruppe bestehend aus Naphthalin, 1,1,2,2,3,3,4-Heptafluorcyclopentan, 1,1-Dichloroctafluorcyclopentan, 1,1,2,2,3,3,4,4-Octafluorcyclohexan, Perfluorcyclohexan, Campher, Dimethyloxalat, Neopentylalkohol, Tetrahydrodicyclopentadien und Pyrazin.

11. Verfahren zum Herstellen eines Substrats, das ein unebenes Muster auf einer Oberfläche aufweist, nach Anspruch 10, zudem umfassend:
einen Schritt des Reinigens der sublimierbaren Substanz vor Schritt (I).

12. Verfahren zum Herstellen eines Substrats, das ein unebenes Muster auf einer Oberfläche aufweist, nach Anspruch 10 oder 11,
wobei das Substrat das unebene Muster mit einer Musterdimension von 30 nm oder weniger auf der Oberfläche aufweist.

13. Verfahren zum Herstellen eines Substrats, das ein unebenes Muster auf einer Oberfläche aufweist, nach Anspruch 12,
wobei das Substrat das unebene Muster mit einer Musterdimension von 20 nm oder weniger auf der Oberfläche aufweist.

## Revendications

1. Composition pour sécher un profil irrégulier comprenant :
une substance sublimable ; et
un solvant dont le point d'ébullition à 1 atm est plus faible qu'un point d'ébullition ou un point de sublimation de la substance sublimable par 5 °C ou plus et dont le point d'ébullition à 1 atm est de 75 °C ou moins,
dans laquelle la substance sublimable est dissoute dans le solvant,
dans laquelle la substance sublimable comprend un ou deux ou plus de deux choisis dans le groupe constitué par un fluoroalcane ayant 3 à 6 atomes de carbone, un fluorocycloalcane ayant 3 à 6 atomes de carbone, un composé dans lequel un atome d'hydrogène du fluoroalcane est remplacé par un atome de chlore, et un composé dans lequel un atome d'hydrogène du fluorocycloalcane est remplacé par un atome de chlore,
ou
dans laquelle la substance sublimable comprend un ou deux ou plus de deux choisis dans le groupe constitué par le naphtalène, le 1,1,2,2,3,3,4-heptafluorocyclopentane, le 1,1-dichlorooctafluorocyclopentane, le 1,1,2,2,3,3,4,4-octafluorocyclohexane, le perfluorocyclohexane, le camphre, l'oxalate de diméthyle, l'alcool néopentylique, le tétrahydrodicyclopentadiène, et la pyrazine.

2. Composition pour sécher un profil irrégulier selon la revendication 1,
dans laquelle un point de congélation de la substance sublimable à 1 atm est de 5 °C ou plus.

3. Composition pour sécher un profil irrégulier selon la revendication 1 ou 2,
dans laquelle le point d'ébullition ou le point de sublimation de la substance sublimable est de 300 °C ou moins.

4. Composition pour sécher un profil irrégulier selon la revendication 1,
dans laquelle la substance sublimable comprend le 1,1,2,2,3,3,4-heptafluorocyclopentane.

5. Composition pour sécher un profil irrégulier selon l'une quelconque des revendications 1 à 4,
dans laquelle une teneur de la substance sublimable est de 1 % en masse ou plus et de 80 % en masse ou moins par rapport à une masse totale de la composition pour sécher un profil irrégulier.

6. Composition pour sécher un profil irrégulier selon l'une quelconque des revendications 1 à 5,
dans laquelle le solvant comprend un ou deux ou plus de deux choisis dans le groupe constitué par des hydrocarbures qui peuvent avoir au moins un des atomes de fluor et des atomes de chlore, des éthers qui peuvent avoir au moins un des atomes de fluor et des atomes de chlore, des alcools qui peuvent avoir au moins un des atomes de fluor et des atomes de chlore et des esters.

7. Composition pour sécher un profil irrégulier selon l'une quelconque des revendications 1 à 6,
dans laquelle le solvant comprend un ou deux ou plus de deux choisis dans le groupe constitué par l'hexane, le trans-1-chloro-3,3,3-trifluoropropène, le cis-1-chloro-3,3,3-trifluoropropène, l'éther de diéthyle, le tétrahydrofurane, le 1,1,1,3,3,3-hexafluoro-2-méthoxypropane, le 1,1,1,2,2,3,3,4,4-nonafluorbutyl éther de méthyle, le 3-méthyl pentane, le cyclopentane, et l'acétate de méthyle.

8. Composition pour sécher un profil irrégulier selon l'une quelconque des revendications 1 à 7,
dans laquelle la composition est utilisée pour traiter un substrat ayant un profil irrégulier avec une dimension de profil de 30 nm ou moins.

9. Composition pour sécher un profil irrégulier selon la revendication 8,
dans laquelle la composition est utilisée pour traiter le substrat ayant un profil irrégulier avec une dimension de profil de 20 nm ou moins.

10. Procédé de fabrication d'un substrat ayant un profil irrégulier sur une surface, le procédé comprenant :
une étape (I) dans laquelle, une composition pour sécher qui contient une substance sublimable et un solvant dont le point d'ébullition à 1 atm est inférieur à un point d'ébullition ou un point de sublimation de la substance sublimable par 5 °C ou plus et dont le point d'ébullition à 1 atm est de 75 °C ou moins, la substance sublimable étant dissoute dans le solvant, est fournie, dans un état de solution, à une portion en retrait du profil irrégulier ;
une étape (II) dans laquelle le solvant dans la portion en retrait est séché et la substance sublimable est coagulée ; et
une étape (III) de sublimation de la substance sublimable,
dans lequel la substance sublimable comprend un ou deux ou plus de deux choisis dans le groupe constitué par un fluoroalcane ayant 3 à 6 atomes de carbone, un fluorocycloalcane ayant 3 à 6 atomes de carbone, un composé dans lequel un atome d'hydrogène du fluoroalcane est remplacé par un atome de chlore et un composé dans lequel un atome d'hydrogène du fluorocycloalcane est remplacé par un atome de chlore,
ou
dans lequel la substance sublimable comprend un ou deux ou plus de deux choisis dans le groupe constitué par le naphtalène, le 1,1,2,2,3,3,4-heptafluorocyclopentane, le 1,1-dichlorooctafluorocyclopentane, le 1,1,2,2,3,3,4,4-octafluorocyclohexane, le perlfuorocyclohexane, le camphre, l'oxalate de diméthyle, l'alcool néopentylique, le tétrahydrodicyclopentadiène et la pyrazine.

11. Procédé de fabrication d'un substrat ayant un profil irrégulier sur une surface selon la revendication 10, comprenant en outre :
une étape de purification de la substance sublimable avant l'étape (I).

12. Procédé de fabrication d'un substrat ayant un profil irrégulier sur une surface selon la revendication 10 ou 11,
dans lequel le substrat a le profil irrégulier avec une dimension de profil de 30 nm ou moins sur la surface.

13. Procédé de fabrication d'un substrat ayant un profil irrégulier sur une surface selon la revendication 12,
dans lequel le substrat a le profil irrégulier avec une dimension de profil de 20 nm ou moins sur la surface.
